# EUROPÄISCHE PATENTSCHRIFT

(11) **EP 0 527 369 B1**
(45) Veröffentlichungstag und Bekanntmachung des Hinweises auf die Patenterteilung: **27.05.1998**
(21) Anmeldenummer: 92112589.4
(22) Anmeldetag: 23.07.1992
(51) Int. Cl.: G03F 7/022, G03F 7/004, G03F 7/115

(54) **Strahlungsempfindliches Aufzeichnungsmaterial aus Schichtträger und positiv arbeitender, strahlungsempfindlicher Schicht mit rauher Oberfläche**
Radiation-sensitive recording material comprising a layer support and a positive-working radiation-sensitive layer having a grained surface
Matériel d'enregistrement sensible aux radiations comprenant un support et une couche positive sensible aux radiations ayant une surface rugueuse

(30) Priorität: 14.08.1991 DE 4126836
(43) Veröffentlichungstag der Anmeldung: 17.02.1993
(73) Patentinhaber: Agfa-Gevaert AG, 51373 Leverkusen (DE)
(72) Erfinder: Frass, Hans Werner, Dr., W-6200 Wiesbaden (DE); Hackmann, Ernst-August, Dr., W-6200 Wiesbaden (DE); Joerg, Klaus, Dr., W-6507 Ingelheim (DE); Könneke, Dietmar, Dr., W-6204 Taunusstein (DE); Neubauer, Rudolf, Dr., W-6227 Oestrich-Winkel (DE); Elsässer, Andreas, Dr., W-6270 Idstein (DE)

(56) Entgegenhaltungen:
- EP-A- 0 021 428
- EP-A- 0 042 104
- EP-A- 0 260 943
- FR-A- 2 301 842

## Beschreibung

Die Erfindung betrifft ein strahlungsempfindliches Aufzeichnungsmaterial, insbesondere zur Herstellung von Flachdruckplatten, aus einem Schichtträger und einer positiv arbeitenden, strahlungsempfindlichen Schicht mit rauher Oberfläche, die als strahlungsempfindliche Verbindung mindestens ein 1,2-Chinondiazid und als wasserunlösliches, in wäßrig-alkalischen Lösungen lösliches oder quellbares Bindemittel ein Polykondensat oder Polymerisat und Füllstoff enthält. Es betrifft weiterhin ein Verfahren zur Herstellung einer Flachdruckplatte, bei dem ein strahlungsempfindliches Aufzeichnungsmaterial zunächst in einem Vakuum-Kontaktkopierrahmen durch eine Filmvorlage hindurch bestrahlt, dann mit einer wäßrig-alkalischen Lösung entwickelt und anschließend gummiert wird.

Die strahlungsempfindliche Schicht in Aufzeichnungsmaterialien zur Herstellung von Flachdruckplatten hat gewöhnlich ein Schichtgewicht von weniger als etwa 3 g/cm². Bildmäßig bestrahlt wird üblicherweise mit UV-Licht. Nach dem Entwickeln und Gummieren kann die fertige Flachdruckplatte noch eingebrannt werden.

Um die Filmvorlage in dem Vakuum-Kontaktkopierrahmen rasch in Kontakt mit dem Aufzeichnungsmaterial zu bringen, Lufteinschlüsse beim Evakuieren zu verhindern und den beim Bestrahlen photochemisch bebildeten Stickstoff ausreichend abzuführen, hat sich eine rauhe Oberfläche der Aufzeichnungsmaterialien als vorteilhaft erwiesen.

Eine rauhe Oberfläche kann vom Anwender selbst unmittelbar vor Verarbeitung der Aufzeichnungsmaterials erzeugt werden, beispielsweise durch Bestäuben mit einem Pulver. Diese Verfahrensweise hat sich jedoch aus verschiedenen Gründen, u. a. ungleichmäßigen Kopierresultaten, nicht durchgesetzt.

Daher wurden von den Herstellern Anstrengungen unternommen, vorsensibilisierte Flachdruckplatten mit einer definiert rauhen Oberfläche zu versehen. So wurde bereits das Prägen der Schichtoberfläche oder das Auswaschen wasserlöslicher Partikel aus der lichtempfindlichen Schicht offenbart (DE-A 18 13 445 = GB-A 1 293 161). Es ist auch bekannt, die Schicht mit einem Treibmittelzusatz zu versehen, der beim Trocknungsprozeß aktiviert wird (EP-A 0 011 648 = US-A 4 371 602). Es ist auch der Zusatz von Harzen zur lichtempfindlichen Schicht bekannt, die beim Trocknungsprozeß agglomerieren (DE-A 29 48 737 = GB-A 2 043 281). Keines dieser Verfahren hat jedoch Eingang in die Produktion von Flachdruckplatten gefunden.

Dagegen hat sich das Aufbringen einer Mattierungsschicht auf die strahlungsempfindliche Schicht als gangbarer Weg erwiesen, wie das Aufbringen gefüllter, entwicklerlöslicher Mattierungsschichten (DE-A 30 09 928 = GB-A 2 046 461). Der Antrag nicht gefüllter, diskontinuierlicher Mattierungsschichten, aufgebracht durch Walzen mit rauher Oberfläche (DE-A 26 06 793 = US-A 4 216 289) ist ebenfalls bekannt. Schließlich kann man entwicklerlösliche Mattierungspulver aufstäuben und fixieren (DE-A 30 03 131 = US-A 4 288 521). Außerdem werden wäßrige Lösungen oder Dispersionen von entwicklerlöslichen Harzen aufgesprüht (DE-A 31 31 570 = GB-A 2 081 919) und getrocknet. Das Aufsprühen der Mattierungschichten kann elektrostatisch erfolgen (EP-A 0 344 985). Ferner ist bekannt, Mattierungsschichten aufzusprühen, die im wesentlichen die gleiche Zusammensetzung wie die strahlungsempfindliche Schicht besitzen (DE-A 34 33 247 = US-A 4 842 982).

Mit diesen Techniken lassen sich Flachdruckplatten fertigen, die sich bei der Kontaktbestrahlung ausgezeichnet bewähren. Nachteilig ist jedoch, daß selbst bei Verwendung entwicklerlöslicher Mattierungsschichten eine geringere Entwicklungsgeschwindigkeit und ein erhöhter Entwicklerverbrauch festzustellen sind sowie durch die zusätzliche Schicht erhebliche Fertigungsmehrkosten anfallen.

Diese Punkte waren Anlaß für die Suche nach Möglichkeiten, der strahlungsempfindlichen Positivkopierschicht durch Zusätze beim Fertigungsprozeß direkt eine rauhe Oberfläche zu verleihen.

In der DE-A 29 26 236 (= CA-A 1 148 014) wird für diesen Zweck der Zusatz von anorganischen oder organischen Füllstoffen mit einem mittleren Teilchendurchmesser von 1 bis 20 µm beschrieben.

Es ist auch bekannt, daß man den Vorteil einer leichteren Dispergierbarkeit der in den Beschichtungslösemitteln unlöslichen Füllstoffe entweder dann erhält, wenn man thermisch gehärtetes Phenol-Formaldehyd-Harz als Füllstoff verwendet (DE-A 31 17 702 = GB-A 2 075 702) oder wenn man Siliciumdioxid-Partikel mit hydrophober Oberfläche, die einen Partikeldurchmesser von kleiner oder gleich 0,5 µm besitzen (JP-A 75-115 548), diesem Füllstoff zusetzt.

All diese Maßnahmen führen noch nicht zu optimalen Ergebnissen, da sich mit diesen Materialien die folgenden Anforderungen nicht gleichzeitig erfüllen lassen. Es sollen
a) die Evakuierungszeiten denen vergleichbar sein, die man beim Einsatz von Mattierungsschichten erhält,
b) die Anfälligkeit für Lufteinschlüsse gering und eine gleichmäßige Rasterübertragung (Rasterruhe) wie bei den Materialien mit Mattierungsschichten gewährleistet sein,
c) das Auflösungsvermögen und die damit verbundene Möglichkeit zur Lichtkorrektur, d.h. zur Filmkanteneliminierung mit Hochbelichtung ohne Verluste in Feinstrich- oder Spitzlichtpartien, möglichst unbeeinträchtigt sein und
d) Hofbildung um die Füllstoffpartikel oder sonstige Defekte, die das Verhalten negativ beeinflussen, vermieden werden.

Es war deshalb Aufgabe der Erfindung, ein strahlungsempfindliches Aufzeichnungsmaterial bereitzustellen, das bei technisch einfacher und kostengünstiger Fertigung die obigen Forderungen erfüllt.

Gelöst wird die Aufgabe mit einem strahlungsempfindlichen Aufzeichnungsmaterial der eingangs genannten Art, das dadurch gekennzeichnet ist, daß die strahlungsempfindliche Schicht bei einem Schichtgewicht von 3 g/m² oder weniger
- als Füllstoff ein Kieselsäureprodukt mit einer mittleren Korngröße von 3 bis 5 µm und einer Ausschlußgrenze von 15 µm in einer Menge enthält, die zur einer Glätte nach Bekk von 20 bis 100 Sekunden (bestimmt nach DIN 53 107, Verfahren A) führt,
- und zusätzlich ein Tensid mit Polysiloxan-Einheiten enthält.

Vorzugsweise besitzt die strahlungsempfindliche Schicht ein Schichtgewicht von 1,5 bis 2,5 g/m². Das Kieselsäureprodukt ist vorzugsweise in einer Menge vorhanden, daß die Glätte der Schicht nach Bekk von 20 bis 80 Sekunden liegt. Vorzugsweise ist das Kieselsäureprodukt hydrophobiert, insbesondere mit Wachs, oder chemisch modifiziert, insbesondere mit Silanen.

Das Tensid ist vorzugsweise in einem Anteil von 0,01 bis 2 Gew.-%, bezogen auf das Trockengewicht der Schicht vorhanden.

Als Kieselsäureprodukte werden synthetische Kieselsäuren und Silikate nach DIN 55 921 verwendet. Hiernach kommen sowohl reines SiO₂ als auch metalloxidhaltige Kieselsäuren zur Anwendung, auch wenn eine genaue Unterscheidung zwischen beiden nicht möglich ist. Daher nähert sich der Begriff "Kieselsäureprodukt" dem gebräuchlichen Ausdruck "silica", der nicht oder nicht immer zwischen Kieselsäuren und Silicaten unterscheidet. Als Kieselsäureprodukte können beispielsweise ^{(R)}Syloid-Typen der Fa. Grace, ^{(R)}Silcron von Lanco, ^{(R)}Gasil von Crosfield, OK/HK-Typen der Degussa und ^{(R)}Satintone der Engelhard-Chemie eingesetzt werden.

Unter "mittlere Korngröße" ist der 50 %-Wert der kumulativen Massen- oder Volumenverteilungskurve zu verstehen, wie er in der entsprechenden DIN-Vorschrift 66 141 festgelegt ist. Die Ausschlußgrenze bezeichnet den 100 %-Wert.

In dieser Vorschrift sind die Grundlagen zur Darstellung von Korn-(Teilchen)-größenverteilungen dargestellt. Sie gelten für alle körnigen Stoffe, unabhängig von der Art des gemessenen Feinheitsmerkmals.

Zur Bestimmung der Kennwerte liegen verschiedene Verfahren vor, wie Sedimentationsmessungen, bildanalytische Auswertung von elektronenmikroskopischen Aufnahmen, Leitfähigkeitsmessungen, Lichtstreuung.

Die Füllstoffmengen des Kieselsäureproduktes, die zur Regulierung von Glättewerten nach Bekk von 20 bis 100 Sekunden, bevorzugt 20 bis 80 Sekunden, erforderlich sind, variieren stark und sind neben der mittleren Korngröße auch vom Schichtgewicht der strahlungsempfindlichen Schicht und von der Rauhigkeit der Schichtträgeroberfläche abhängig.

Die Bestimmung der Glätte nach Bekk erfolgt nach DIN 53 107, Verfahren A, bei dem man die Zeit mißt, in der infolge des durchgesaugten Luftvolumens der Druck in dem Vakuumbehälter für die Meßprobe von -507 mbar auf -489 mbar ansteigt.

Das Kieselsäureprodukt ist vorzugsweise in einem Anteil von 0,01 bis 10 Gew.-%, insbesondere 0,1 bis 5 Gew.-%, bezogen auf das Trockengewicht der Schicht, vorhanden.

Die als Füllstoffe verwendeten Kieselsäureprodukte werden, um eine leichtere Dispergierbarkeit zu erzielen, vorzugsweise durch Beschichtung, z.B. mit Wachs, oder durch chemische Modifizierung, z.B. mit Silanen, hydrophobiert.

Die verwendeten Tenside sind bevorzugt Dialkylsiloxane, die zusätzlich durch Alkylenoxideinheiten oder Säureeinheiten modifiziert sein können. Der für eine einwandfreie Beschichtung ohne Hofbildung erforderliche Anteil hängt von der Füllstoffmenge ab. In der Regel sind 0,01 bis 2, insbesondere 0,05 bis 1 Gew.-%, bezogen auf das Trockengewicht der Schicht, ausreichend.

Als Beispiele für verwendete Tenside werden Produkte wie ^{(R)}Tegopren der Th.Goldschmidt AG, ^{(R)}Edaplan (Münzing), ^{(R)}Byk (Byk-Chemie), ^{(R)}Baysilon-Typ (Bayer AG) oder auch verschiedene Siliconöle der Wacker-Chemie genannt.

Als 1,2-Chinondiazid werden vorzugsweise 1,2-Naphthochinon-2-diazid-4- oder -5-sulfonylderivate eingesetzt. Es werden insbesondere die Ester bevorzugt.

Geeignete Naphthochinondiazide sind aus DE-C 938 233 (= US-A 3 106 465, US-A 3 180 733) und DE-A 28 28 037 (= US-A 4 266 001) bekannt. Der Anteil der Naphthochinondiazidverbindungen in der strahlungsempfindlichen Schicht beträgt im allgemeinen 3 bis 50 Gew.-%, vorzugsweise 8 bis 25 Gew.-%, bezogen auf den Gehalt ihrer nichtflüchtigen Bestandteile.

Die bei vielen Positiv-Kopiermaterialien auf Basis von 1,2-Chinondiaziden bewährten Novolak-Polykondensate haben sich als Bindemittel auch hier als vorteilhaft erwiesen. Die Novolake können zusätzlich in bekannter Weise durch Umsetzung eines Teils ihrer Hydroxygruppen, z. B. mit Chloressigsäure, Isocyanaten, Epoxiden oder Carbonsäureanhydriden modifiziert sein. Als weitere alkalilösliche bzw. in Alkali quellbare Bindemittel sind Polyhydroxyphenylharze, die durch Kondensation aus Phenolen und Aldehyden oder Ketonen hergestellbar sind, oder Polymerisate bzw. Mischpolymerisate aus Styrol und Maleinsäureanhydrid oder Polyvinylphenole einsetzbar. Vorteilhaft kann ein Polymerisat bzw. Copolymerisat eines mit einem mehrwertigen Phenol veresterten Acryl-bzw. Methacrylsäureesters eingesetzt werden. Die Art und Menge des alkalilöslichen Harzes kann je nach Anwendungszweck verschieden sein; bevorzugt werden Anteile am Gesamtfeststoff zwischen 90 und 30, insbesondere zwischen 85 und 55 Gew.-%.

Die Bindemittel weisen vorzugsweise einen Gehalt an phenolischen Hydroxylgruppen von 1 bis 15 mmol/g und ein Molekulargewicht unter 100 000, insbesondere von 5 000 bis 100 000, auf.

Weiterhin können noch zahlreiche andere Harze mitverwendet werden. Als besonders vorteilhaft hat sich eine Kombination aus einem Kresol-Formaldehyd-Novolak und einem nicht plastifizierten, vorzugsweise alkylveretherten Melamin-Formaldehyd-Harz erwiesen. Ferner können als Harze zusätzlich Epoxyharze und Vinyl-Mischpolymerisate der ihnen zugrundeliegenden Monomeren sowie hydrierte oder teilhydrierte Kolophoniumderivate vorhanden sein. Der günstige Anteil an diesen Harzen richtet sich nach den anwendungstechnischen Erfordernissen und nach dem Einfluß auf die Entwicklungsbedingungen. Er beträgt im allgemeinen nicht mehr als 40, bevorzugt etwa 1 bis 20 Gew.-%, bezogen auf alkalilösliches Bindemittel. In geringen Mengen kann die strahlungsempfindliche Schicht für spezielle Erfordernisse, wie Flexibilität, Haftung, Glanz und Färbung, außerdem noch Substanzen wie Polyglykole, Cellulose-Derivate, wie Ethylcellulose, Netzmittel, Farbstoffe, Haftvermittler und feinteilige Pigmente sowie bei Bedarf UV-Absorber enthalten.

Ferner können der strahlungsempfindlichen Schicht für den Farbumschlag nach dem Belichten noch geringe Mengen von strahlungsempfindlichen Komponenten beigefügt werden, die beim Belichten vorzugsweise starke Säuren bilden bzw. abspalten und in einer Folgereaktion mit einem geeigneten Farbstoff einen Farbumschlag hervorrufen. Bevorzugt wird ein kationischer Triarylmethan- oder Methinfarbstoff verwendet. Als strahlungsempfindliche Komponenten sind z. B. 1,2-Naphthochinondiazid-4-sulfonsäurechlorid, chromophor substituierte Halogenmethyl-s-triazine oder Diazoniumverbindungen in Form ihrer Salze mit komplexen Säuren, wie Borfluorwasserstoffsäure oder Hexafluorphosphorsäure, geeignet.

Zur Beschichtung eines geeigneten Schichtträgers, d.h. zur Herstellung des lichtempfindlichen Aufzeichnungsmaterials, wird das Gemisch im allgemeinen in einem Lösemittel gelöst. Die Wahl der Lösemittel ist auf das vorgesehene Beschichtungsverfahren, die Schichtdicke und die Trocknungsbedingungen abzustimmen. Geeignete Lösemittel sind Ketone, wie Methylethylketon, chlorierte Kohlenwasserstoffe, wie Trichlorethylen und 1,1,1-Trichlorethan, Alkohole, wie n-Propanol, Ether, wie Tetrahydrofuran, Glykolmonoether, wie Ethylenglykolmonoalkylether, Propylenglykolmonoalkylether und Ester, wie Butylacetat oder Propylenglykolalkyletheracetat. Es können auch Gemische verwendet werden, die zudem noch für spezielle Zwecke Lösemittel wie Acetonitril, Dioxan oder Dimethylformamid enthalten können. Prinzipiell sind alle Lösemittel verwendbar, die mit den Schichtkomponenten nicht irreversibel reagieren. Monoether von Glykolen, insbesondere Ethylenglykolmonomethylether und Propylenglykolmethylether werden besonders bevorzugt.

Als Schichtträger werden meist Metalle verwendet. Bevorzugt werden für Offsetdruckplatten eingesetzt: walzblankes, mechanisch oder elektrochemisch aufgerauhtes und gegebenenfalls anodisiertes Aluminium, das zudem noch chemisch, z. B. mit Polyvinylphosphonsäure, Silikaten, Phosphaten, Hexafluorzirkonaten oder mit hydrolysiertem Tetraethylorthosilikat, vorbehandelt sein kann.

Die Beschichtung des Schichtträgers erfolgt in bekannter Weise durch Aufschleudern, Sprühen, Tauchen, Walzen, mit Breitschlitzdüsen, Rakeln oder durch Gießer-Antrag. Belichtet wird mit den technisch üblichen Lichtquellen.

Zum Entwickeln werden wäßrig-alkalische Lösungen abgestufter Alkalität verwendet, vorzugsweise mit einem pH-Wert von 10 bis 14, die auch kleine Mengen organischer Löse- oder Netzmittel enthalten können.

Zur Herstellung einer Druckform wird das lichtempfindliche Aufzeichnungsmaterial unter einer Positiv-Vorlage im Vakuum-Kontakt-Rahmen bildmäßig belichtet und anschließend mit einem wäßrig-alkalischen Entwickler entwickelt. Zur bildmäßigen Belichtung können Röhrenlampen, Xenonimpulslampen, Metallhalogenid dotierte Quecksilberdampflampen oder Kohlenbogenlampen verwendet werden.

Die Erfindung betrifft auch ein Verfahren zur Her-stellung einer Flachdruckplatte durch Evakuieren einer Filmvorlage und dem strahlungsempfindlichen Aufzeichnungsmaterial in einem Vakuumkopierrahmen, Belichten, Entwickeln mit einer wäßrig-alkalischen Lösung und Gummieren, das dadurch gekennzeichnet ist, daß man ein Aufzeichnungsmaterial nach Anspruch 1 verwendet.

Durch die Erfindung wird eine gleichzeitige Erfüllung der Anforderungen der Praxis bezüglich der Evakuierzeiten, der Rasterruhe und der geringen Anfälligkeit für Lufteinschlüsse, für das Auflösevermögen und bezüglich der einwandfreien Beschichtungsstruktur erreicht. Infolge der Tensidanwesenheit tritt keine Hofbildung auf.

Die Erfindung wird anhand der folgenden Beispiele näher erläutert, Vergleichsbeispiele sind mit einem * gekennzeichnet. Die verwendeten Abkürzungen stehen für:
- D: mittlere Korngröße in µm
- A: Ausschlußgrenze in µm
- G: Glätte-Wert nach Bekk in Sekunden
- T: Evakuierzeit in Sekunden zur Kontaktierung Filmvorlage-Flachdruckplatte
- R: Rasterruhe, visuell bewertet wird die Gleichmäßigkeit der Wiedergabe eines großflächigen 60er-Rasters mit 20 % Flächendeckung:
+ = keine Ausbrüche,
0 = vereinzelt Ausbrüche, leichte Rasterunruhe,
- = viele Ausbrüche, starke Rasterunruhe
- C: Corona = Breite der Zone in mm um einen 300 µm dicken Abstandshalter zwischen Druckplatte und 60er-Rasterfilm mit 20 % Flächendeckung in dem die Rasterpunkte nicht wiedergegeben werden. Bei diesem Test wird die Anfälligkeit gegenüber Lufteinschlüssen untersucht
- K: Nummer der ersten vollständig wiedergegebenen Linie (von 1 bis 40) in Feld 3 des Kontaktkontrollstreifens der FOGRA
- U: Mikrolinienanzeige im UGRA-Offset-Testkeil
- H: Hofbildung um Füllstoffe:
+ = nicht vorhanden
- = vorhanden

### Beispiel 1:

Eine in Salzsäure elektrolytisch aufgerauhte (Rz-Wert nach DIN 4768:5,0 µm), in Schwefelsäure zwischengebeizte und in Schwefelsäure eloxierte (Oxidgewicht 4,0 g/m²) Aluminiumfolie der Stärke 0,3 mm wird mit Polyvinylphosphonsäure entsprechend DE-A 16 21 478 (= US-A 4 153 461) hydrophiliert und dann mit folgender Kopierlacklösung beschichtet: (Gewichtsteile = Gt)
- 5,00 Gt: Kresol-Formaldehyd-Novolakharz mit einer Hydroxylzahl von 420 nach DIN 53 783/ 53 240 und einem Gewichtsmittelwert nach GPC von 10 000 (Polystyrol-Standard),
- 1,20 Gt: Veresterungsprodukt von 3 mol 1,2-Naphthochinon-2-diazid-5-sulfonylchlorid und 1 mol 2,3,4-Trihydroxybenzophenon,
- 0,15 Gt: 1,2-Naphthochinon-2-diazid-4-sulfonylchlorid,
- 0,05 Gt: Victoriareinblau (C.I. 44 045) und
- x Gt: Kieselsäurefüllstoff, ^{(R)}Syloid (Fa. Grace), entsprechend Tabelle 1,
- y Gt: Tensid auf Basis von Dimethylsiloxan- und Alkylenoxideinheiten, ^{(R)}Edaplan LA (Münzing, Heilbronn), Menge entsprechend Tabelle 1,
aufgefüllt auf
- 100 Gt: mit einem Lösemittelgemisch aus Methylethylketon und Propylenglykol-monomethylether (40/60).

Der Kopierlackfilm wird 1 Minute bei 125 °C getrocknet. Das Schichtgewicht beträgt 2,4 g/m².

Die Platten werden in einem Vakuum-Kontaktkopierrahmen durch Evakuieren mit einer Montage des Testvorlagen kontaktiert, mit einer 5-KW-Metallhalogenid dotierten Quecksilberdampflampe im Abstand von 110 cm so belichtet, daß nach Entwicklung eine offene Stufe 4 im UGRA-Offset-Testkeil resultiert, was einer Hochbelichtung zur Filmkanteneliminierung entspricht. Entwickelt wird 30 Sekunden lang in einem Kaliumsilikat-Entwickler mit einem Gesamtalkaligehalt von 0,95 mol/l.

Die in der beigefügten Tabelle 1 wiedergegebenen Resultate zeigen, daß mit den erfindungsgemäßen Aufzeichnungsmaterialien die gleichzeitige Erfüllung der Anforderungen bezüglich Evakuierzeiten (T), Rasterruhe (R) und geringer Anfälligkeit für Lufteinschlüsse (C,K), Auflösungsvermögen (U) und einwandfreier Beschichtungsstruktur (H) im Gegensatz zu den bekannten Materialien gegeben ist.

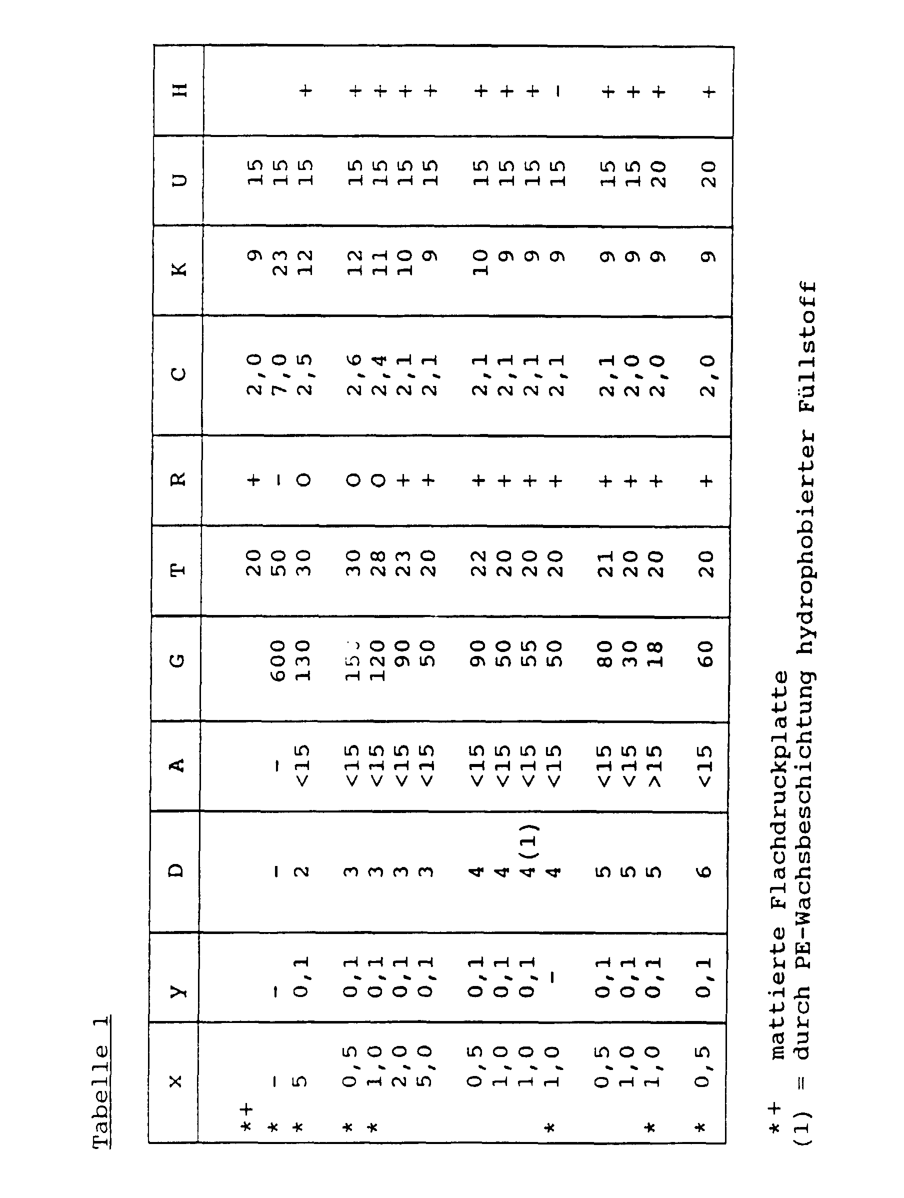

### Beispiel 2:

Eine in Salzsäure elektrolytisch aufgerauhte (Rz-Wert nach DIN 4768: 3,2 µm), in Schwefelsäure zwischengebeizte und in Schwefelsäure eloxierte (Oxidgewicht 2,0 g/m²) Aluminiumfolie der Stärke 0,3 mm wird mit Polyvinylphosphonsäure entsprechend DE-A 16 21 478 (= US-A 4 153 461) hydrophiliert und dann mit folgender Kopierlacklösung beschichtet: (Gewichtsteile = Gt)
- 4,80 Gt: Kresol-Formaldehyd-Novolakharz mit einer Hydroxylzahl von 420 nach DIN 53 783/ 53 240 und einem Gewichtsmittelwert nach GPC von 10 000 (Polystyrol-Standard),
- 1,05 Gt: Veresterungsprodukt von 3 mol 1,2-Naphthochinon-2-diazid-4-sulfonylchlorid und 1 mol 2,3,4-Trihydroxybenzophenon,
- 0,05 Gt: 2-(4-Styrylphenyl)-4,6-bis-trichlormethyl-s-triazin,
- 0,10 Gt: Kristallviolett (C.I. 42 555) und
- x Gt: Kieselsäurefüllstoff, (^{(R)}Syloid der Fa. Grace) entsprechend Tabelle 2,
- y Gt: Tensid auf Basis von Dimethylsiloxan- und Alkylenoxideinheiten, (^{(R)}Tegopren der Th. Goldschmidt AG), Menge entsprechend Tabelle 2,
aufgefüllt auf
- 100 Gt: mit einem Lösemittelgemisch aus Tetrahydrofuran und Propylenglykolmonomethylether (55/45).

Der Kopierlackfilm wird 1 Minute bei 125 °C getrocknet. Das Schichtgewicht beträgt 1,8 g/m².

Die Verarbeitung der Flachdruckplatten mit einer umkehrbaren Positivschicht erfolgt gemäß Beispiel 1.

Die in Tabelle 2 wiedergegebenen Resultate bestätigen die unter Beispiel 1 beschriebenen Ergebnisse für dieses erfindungsgemäße Aufzeichnungsmaterial.

**Tabelle 2**

| x | y | D | A | G | T | R | C | K | U | H |
|---|---|---|---|---|---|---|---|---|---|---|
| *+ | | | | | 20 | + | 2,0 | 9 | 15 | |
| * - | - | - | - | 650 | 52 | - | 6,8 | 21 | 15 | |
| * 5 | 0,1 | 2 | <15 | 140 | 30 | o | 2,4 | 12 | 15 | + |
| | | | | | | | | | | |
| * 0,5 | 0,1 | 3 | <15 | 145 | 30 | o | 2,6 | 12 | 15 | + |
| * 1,0 | 0,1 | 3 | <15 | 115 | 27 | o | 2,4 | 11 | 15 | + |
| 2,0 | 0,1 | 3 | <15 | 85 | 22 | + | 2,1 | 10 | 15 | + |
| 5,0 | 0,1 | 3 | <15 | 45 | 20 | + | 2,1 | 9 | 15 | + |
| | | | | | | | | | | |
| 0,5 | 0,1 | 4 | <15 | 90 | 22 | + | 2,1 | 10 | 15 | + |
| 1,0 | 0,1 | 4 | <15 | 50 | 20 | + | 2,1 | 9 | 15 | + |
| 1,0 | 0,1 | 4(1) | <15 | 50 | 20 | + | 2,1 | 9 | 15 | + |
| * 1,0 | - | 4 | <15 | 50 | 20 | + | 2,1 | 9 | 15 | - |
| | | | | | | | | | | |
| 0,5 | 0,1 | 5 | <15 | 70 | 21 | + | 2,1 | 9 | 15 | + |
| 1,0 | 0,1 | 5 | <15 | 35 | 20 | + | 2,0 | 9 | 15 | + |
| * 1,0 | 0,1 | 5 | >15 | 20 | 20 | + | 2,0 | 9 | 20 | + |
| | | | | | | | | | | |
| * 0,5 | 0,1 | 6 | <15 | 50 | 20 | + | 2,0 | 9 | 20 | + |

| | | | | | | | | | | |
|---|---|---|---|---|---|---|---|---|---|---|
| *+ mattierte Flachdruckplatte | | | | | | | | | | |
| (1) = durch PE-Wachsbeschichtung hydrophobierter Füllstoff | | | | | | | | | | |

## Patentansprüche

1. Strahlungsempfindliches Aufzeichnungsmaterial aus einem Schichtträger und einer positiv arbeitenden, strahlungsempfindlichen Schicht mit rauher Oberfläche, die als strahlungsempfindliche Verbindung mindestens ein 1,2-Chinondiazid und als wasserunlösliches und in wäßrig-alkalischen Lösungen lösliches oder quellbares Bindemittel ein Polykondensat oder Polymerisat und Füllstoff enthält, das dadurch gekennzeichnet ist, daß die strahlungsempfindliche Schicht bei einem Schichtgewicht von 3 g/m² oder weniger
- als Füllstoff ein Kieselsäureprodukt mit einer mittleren Korngröße von 3 bis 5 µm und einer Ausschlußgrenze von 15 µm in einer Menge enthält, die zur einer Glätte nach Bekk von 20 bis 100 Sekunden (bestimmt nach DIN 53 107, Verfahren A) führt
- und zusätzlich ein Tensid mit Polysiloxan-Einheiten enthält.

2. Material nach Anspruch 1, dadurch gekennzeichnet, daß die strahlungsempfindliche Schicht ein Schichtgewicht von 1,5 bis 2,5 g/m² besitzt.

3. Material nach Anspruch 1 oder 2, dadurch gekennzeichnet, daß das Kieselsäureprodukt in einer Menge vorhanden ist, die zur einer Glätte der Schicht von 20 bis 80 Sekunden führt.

4. Material nach den Ansprüchen 1 bis 3, dadurch gekennzeichnet, daß das Kieselsäureprodukt in einem Anteil von 0,01 bis 10 Gew.-%, bezogen auf das Trockengewicht der Schicht, vorhanden ist.

5. Material nach den Ansprüchen 1 bis 4, dadurch gekennzeichnet, daß das Kieselsäureprodukt hydrophobiert ist, bevorzugt mit Wachs oder durch chemische Modifizierung mit Silanen.

6. Material nach Anspruch 1, dadurch gekennzeichnet, daß das Tensid in einem Anteil von 0,01 bis 2 Gew.-%, bezogen auf das Trockengewicht der Schicht, vorhanden ist.

7. Material nach Anspruch 1 oder 6, dadurch gekennzeichnet, daß das Tensid ein Dialkylsiloxan ist, das durch Alkylenoxid-Einheiten modifiziert sein kann.

8. Material nach Anspruch 1, dadurch gekennzeichnet, daß das 1,2-Chinondiazid ein 1,2-Naphthochinon-2-diazid-4-oder -5-sulfonylderivat ist.

9. Material nach Anspruch 1, dadurch gekennzeichnet, daß das Bindemittel einen Gehalt an phenolischen Hydroxylgruppen von 1 bis 15 mmol/g und ein Molekulargewicht unter 100 000 aufweist.

10. Material nach Anspruch 1, dadurch gekennzeichnet, daß die strahlungsempfindliche Schicht eine Komponente, die bei Bestrahlung eine starke Säure bildet, und einen Farbstoff, bevorzugt einen kationischen Triarylmethan- oder Methinfarbstoff, der unter der Säureeinwirkung einen Farbumschlag zeigt, enthält.

11. Verfahren zur Herstellung einer Flachdruckplatte, bei dem ein strahlungsempfindliches Aufzeichnungsmaterial zunächst in einem Vakuum-Kontaktkopierrahmen durch eine Filmvorlage hindurch bestrahlt, dann mit einer wäßrig-alkalischen Lösung entwickelt und anschließend gummiert wird, dadurch gekennzeichnet, daß man ein Aufzeichnungsmaterial nach Anspruch 1 verwendet.

## Claims

1. Radiation-sensitive recording material comprising a layer support and a positive-working, radiationsensitive layer having a rough surface, in which said material contains at least one 1,2 quinone diazide as the radiation-sensitive compound and a polycondensation product or polymer and filler as the binder insoluble in water and soluble or swellable in aqueous alkaline solutions, in which said material is characterised in that, at a layer weight of 3 g/m² or less, the radiation-sensitive layer contains
- a silica product as the filler having an average grain size of 3 to 5 µm and an exclusion limit of 15 µm in a quantity which results in a Bekk smoothness of 20 to 100 seconds (determined to DIN 53 107, method A)
- and additionally a surfactant having polysiloxane units.

2. Material according to claim 1, characterised in that the radiation-sensitive layer has a layer weight of 1.5 to 2.5 g/m².

3. Material according to claim 1 or 2, characterised in that the silica product is present in a quantity which results in a layer smoothness of 20 to 80 seconds.

4. Material according to claims 1 to 3, characterised in that the silica product is present in a proportion of 0.01 to 10 wt.%, relative to the dry weight of the layer.

5. Material according to claims 1 to 4, characterised in that the silica product is rendered hydrophobic, preferably with wax or by chemical modification with silanes.

6. Material according to claim 1, characterised in that the surfactant is present in a proportion of 0.01 to 2 wt.%, relative to the dry weight of the layer.

7. Material according to claim 1 or 6, characterised in that the surfactant is a dialkylsiloxane, which may be modified by alkylene oxide units.

8. Material according to claim 1, characterised in that the 1,2-quinone diazide is a 1,2-naphthoquinone-2-diazide-4- or -5-sulphonyl derivative.

9. Material according to claim 1, characterised in that the binder has a content of phenolic hydroxyl groups from 1 to 15 mmol/g and a molecular weight of below 100000.

10. Material according to claim 1, characterised in that the radiation-sensitive layer contains a component which forms a strong acid on irradiation and a dye, preferably a cationic triarylmethane or methine dye, which exhibits a colour change under the action of acid.

11. Process for the production of a planographic printing plate in which a radiation-sensitive recording material is first irradiated through a film original in a vacuum printing frame, then developed with an aqueous alkaline solution and subsequently gummed, characterised in that a recording material according to claim 1 is used.

## Revendications

1. Matériau d'enregistrement sensible aux rayonnements constitué par un support de couche et par une couche sensible aux rayonnements, à effet positif, ayant une surface rendue rugueuse, qui contient comme composé sensible aux rayonnements au moins un 1,2-quinonediazide et comme liant insoluble dans l'eau et soluble ou susceptible de gonfler dans les solutions alcalines aqueuses un polycondensat ou un polymère, et une charge, qui est caractérisé en ce que la couche sensible aux rayonnements contient pour une masse de couche de 3 g/m² ou moins
- comme charge un produit à base d'acide silicique ayant une taille moyenne de grains de 3 à 5 µm et une limite d'exclusion de 15 µm en une quantité qui conduit à un lissé selon Bekk de 20 à 100 s (déterminé selon DIN 53 107, procédé A),
- et en outre un tensioactif comportant des unités polysiloxanes.

2. Matériau selon la revendication 1, caractérisé en ce que la couche sensible aux rayonnements possède une masse de couche de 1,5 à 2,5 g/m².

3. Matériau selon la revendication 1 ou 2, caractérisé en ce que le produit à base d'acide silicique est présent en une quantité qui conduit à un lissé de la couche de 20 à 80 s.

4. Matériau selon les revendications 1 à 3, caractérisé en ce que le produit à base d'acide silicique est présent en une proportion de 0,01 à 10 % en masse par rapport à la masse sèche de la couche.

5. Matériau selon les revendications 1 à 4, caractérisé en ce que le produit à base d'acide silicique est rendu hydrophobe, de préférence avec une cire ou par modification chimique avec des silanes.

6. Matériau selon la revendication 1, caractérisé en ce que le tensioactif est présent en une proportion de 0,01 à 2 % en masse par rapport à la masse sèche de la couche.

7. Matériau selon la revendication 1 ou 6, caractérisé en ce que le tensioactif est un dialkylsiloxane qui peut être modifié par des unités d'oxyde d'alkylène.

8. Matériau selon la revendication 1, caractérisé en ce que le 1,2-quinonediazide est un dérivé de 1,2-naphtoquinone-2-diazide-4- ou -5-sulfonyle.

9. Matériau selon la revendication 1, caractérisé en ce que le liant présente une teneur en groupes hydroxyles phénoliques de 1 à 15 mmol/g et une masse moléculaire inférieure à 100 000.

10. Matériau selon la revendication 1, caractérisé en ce que la couche sensible aux rayonnements contient un composant qui forme un acide fort lors de l'exposition, et un colorant, de préférence un colorant cationique de triarylméthane ou méthinique, qui présente un changement de couleur sous l'effet de l'acide.

11. Procédé de production d'une plaque d'impression à plat dans lequel un matériau d'enregistrement sensible aux rayonnements est tout d'abord exposé dans un châssis-presse à contact sous vide au travers d'un original, puis développé avec une solution alcaline aqueuse et ensuite gommé, caractérisé en ce que l'on utilise un matériau d'enregistrement selon la revendication 1.
